# EUROPEAN PATENT APPLICATION

(11) **EP 2 282 311 A1**
(43) Date of publication of application: **09.02.2011**
(21) Application number: 09754435.7
(22) Date of filing: 27.05.2009
(51) Int. Cl.: G11B 7/254, C08F 2/44, C08F 2/50, C08F 290/06, C09D 4/00, C09D 7/12, C09D 163/10, C09D 175/14, G11B 7/24, G11B 7/257, G11B 7/258, G11B 7/26

(54) **ULTRAVIOLET-CURING RESIN COMPOSITION FOR OPTICAL DISK, CURED MATERIAL AND OPTICAL DISK**

(30) Priority: 30.05.2008 JP 2008142463
(71) Applicant: Nippon Kayaku Kabushiki Kaisha, Tokyo 102-8172 (JP)
(72) Inventor: KOBAYASHI, Daisuke, Tokyo 115-8588 (JP); NAITOU, Masahiro, Tokyo 115-8588 (JP); MIZUTANI, Go, Tokyo 115-8588 (JP); TAKAHASHI, Hitoshi, Tokyo 115-8588 (JP); TOKUDA, Kiyohisa, Tokyo 115-8588 (JP)
(74) Representative: Gille Hrabal Struck Neidlein Prop Roos
(86) International application number: PCT/JP2009/002327
(87) International publication number: WO 2009/144926

(57) **Abstract**

The present invention relates to an ultraviolet-curable resin composition for an optical disk containing a sulfur-containing compound (A) represented by the following formula (1): 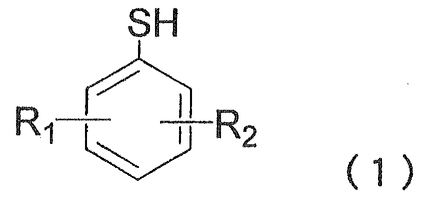 (wherein, R₁ and R₂ each dependently represent a hydrogen atom, a hydroxy group, an alkyloxy group, an alkyl group, an aryl group, a carboxy group, an alkylthio ether group or a halogen atom)
a photopolymerizable compound (B) and a photopolymerization initiator (C), and an optical disk having a thin film of the cured product of said resin composition, particularly an optical disk having a reflective film comprising silver or a silver alloy; and said optical disk is prevented from changing the properties of its reflective film comprising silver or a silver alloy, and thus has a higher durability.

## Description

### Technical Field

The present invention relates to an optical disk having a reflective film comprising silver or a silver alloy.

### Background Art

At present, DVDs in practical use are broadly classified into DVD-ROM where information such as movies has been recorded in disk production or recordable DVD which is a type where no information is recorded in its production and information is recorded on a dye recording layer or an inorganic recording layer by consumers themselves. The above DVD-ROM include, in terms of recording layer structure, DVD-5 having a single recording layer of single-sided read and a recording capacity of around 5 gigabytes, DVD-9 having a dual recording layer of single-sided read and having a recording capacity of around 9 gigabytes, DVD-10 having a dual recording layer of double-sided read and having a recording capacity of around 10 gigabytes, DVD-18 having a quadruple recording layer of double-sided read and having a recording capacity of 18 gigabytes, and the like. At present, DVD-9 is the mainstream because it has enough recording capacity to record an about 2.5 hour movie. DVD-9 is produced by laminating a 0.6 mm polycarbonate substrate equipped with a total reflective film comprising an aluminum alloy and a 0.6 mm polycarbonate substrate equipped with a semitransparent reflective film. It is the mainstream to use inexpensive and highly reflective silver or a silver alloy as a semitransparent reflective film. On the other hand, as recordable DVD, a lot of formats such as DVD-R, DVD+R, DVD-RW, DVD+RW and DVD-RAM exist. The currently mainstream DVD-R, DVD-RW, DVD+R and DVD+RW are a type having a single-sided single layer and produced by bonding a 0.6 mm polycarbonate substrate and a 0.6 mm polycarbonate substrate equipped with a recording layer comprising an organic coloring matter or an inorganic compound and a reflective film layer. As a material of the reflective film layer, inexpensive and highly reflective silver or a silver alloy is used.

In addition, recently, Blu-ray Disc (Blu-ray Disc: BD) and HD-DVD of a single layer type having a recording capacity about 5 times of DVD are on the market. In particular, Blu-ray Disc is a disk having a structure where a recording layer is formed on a transparent or opaque plastic substrate and then an about 0.1 mm light transmitting layer is laminated on said recording layer, and where recording/reproducing is carried out via the light transmitting layer. In Blu-ray Disc, it is also the mainstream to use silver or a silver alloy for a reflective film as well as DVD.

However, silver or silver alloys are also easily oxidized, posing the problem that a silver or silver alloy reflective film changes in properties under the circumstances of high temperature and high humidity, which leads to increased read errors.
As a means to solve this problem, Patent Literature 1 proposes an ultraviolet-curable type protective coating resin for CD-R, characterized by containing an alkylenethiol compound and Patent Literature 2 proposes an ultraviolet-curable type protective coating resin for CD-R, characterized by containing an alkylthio ether compound.

In addition, generally, a protective coating layer for CD-R have a film thickness of approximately 10 µm and is thus thin, resulting in less influence of stress after curing, whereby a resin having a high crosslink density and good durability is used, and therefore even the alkylenethiol compound or the alkylthio ether compound described in the above Patent Literatures can achieve prevention of change in properties of the silver or silver alloy reflective film. On the other hand, an adhesive layer for DVD and the like and a light transmitting layer for Blu-ray Disc and the like is more thicker compared with the protective coating layer for CD-R, whereby if a resin having a higher crosslink density is used, warp of the substrate is increased, so the resin having such a high crosslink density is not currently used. Therefore, even though the above alkylenethiol compound or alkylthio ether compound, which is intended to blend in a protective coating resin having a high crosslink density, is mixed into a currently-used resin composition for adhesive layers of DVD and the like or for light transmitting layers of Blu-ray Disc and the like, said composition cannot fully achieve the prevention effect on change in properties of the silver or silver alloy reflective film.

### Prior Art Literature

### Patent Literatures

Patent Literature 1: JP 3861589 B
Patent Literature 2: JP 4016669 B

### Disclosure of the Invention

### Problems to Be Solved by the Invention

it is an object of the present invention to provide an ultraviolet-curable resin composition (ultraviolet-curable type resin composition) which can impart a higher durability to an optical disk having a reflective film comprising silver or a silver alloy, even in the case where a resin having a high crosslink density used in protective films for CD-R is not used; and an optical disk having a light-cured film of said composition on a reflective film comprising silver or a silver alloy.

### Means of Solving the Problems

The present inventors have intensively studied to solve the above problems and found that an ultraviolet-curable resin composition containing a sulfur-containing compound represented by the formula (1) exhibit excellent durability and light fastness in an optical disk having a reflective film comprising silver or a silver alloy, and the present invention has been completed.

That is, the present invention relates to:
(1) An ultraviolet-curable resin composition for an optical disk having a reflective film comprising silver or a silver alloy which contains a sulfur-containing compound (A) represented by the following formula (1):

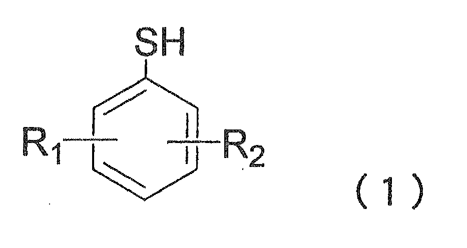

(wherein, R₁ and R₂ each independently represent a hydrogen atom, a hydroxy group, an alkyloxy group, an alkyl group, an aryl group, a carboxy group, an alkylthio ether group or a halogen atom),
a photopolymerizable compound (B) and a photopolymerization initiator (C),
(2) The ultraviolet-curable resin composition for an optical disk according to the above (1), which contains 0.001 to 5% by weight of the sulfur-containing compound (A) represented by the above formula (1) relative to the composition,
(3) The ultraviolet-curable resin composition for an optical disk according to the above (1), wherein the sulfur-containing compound (A) represented by the above formula (1) is thiophenol, 4-mercaptophenol, 3-mercaptophenol, 4-methoxythiophenol, 4-mercapto-2-methylphenol, 4-mercapto-2-ethylphenol, 3-ethyl-4-hydroxythiophenol, thiosalicylic acid, 4-tert-butylthiophenol or 4-chlorothiophenol,

(4) The ultraviolet-curable resin composition for an optical disk according to the above (1), which contains at least either epoxy (meth)acrylate or urethane (meth)acrylate (B-1) as the photopolymerizable compound (B),
(5) The ultraviolet-curable resin composition for an optical disk according to the above (4), which further contains a (meth)acrylate monomer (B-2) as the photopolymerizable compound (B),
(6) The ultraviolet-curable resin composition for an optical disk according to the above (5), wherein the (meth)acrylate monomer (B-2) is one or more kinds selected from the group consisting of dicyclopentenyloxyethyl (meth)acrylate, dipropylene glycol di(meth)acrylate, tripropylene glycol di(meth)acrylate, 1,6-hexanediol di(meth)acrylate, phenoxyethyl (meth)acrylate, phenoxypolyethylene glycol (meth)acrylate, 2-hydroxy-3-phenoxypropyl(meth)acrylate and ethylene oxide-modified bisphenol A type di(meth)acrylate,
(7) The ultraviolet-curable resin composition for an optical disk according to any one of the above (4) to (6), wherein the photopolymerizable compound (B) further contains phosphoric acid (meth)acrylate,

(8) The ultraviolet-curable resin composition for an optical disk according to the above (1), wherein the photopolymerization initiator (C) is one or more kinds selected from the group consisting of 1-hydroxycyclohexylphenyl ketone 2-benzyl-2-dimethylamino-1-(4-morpholinophenyl)-butan-1-one, 2,4,6-trimethylbenzoyldiphenylphosphine oxide, bis(2,4,6-trimethylbenzoyl)-phenylphosphine oxide, 2-hydroxy-2-methyl-[4-(1-methylvinyl)phenyl]propanol oligomer, 2-hydroxy-1-{4-[4-(2-hydroxy-2-methyl-propionyl)-benzyl]-phenyl}-2-methyl-propan-1-one and 1-[4-(2-hydroxyethoxy)-phenyl-]-2-hydroxy-2-methyl-1-propan-1-one,
(9) A cured product obtained by irradiating the ultraviolet-curable resin composition for an optical disk according to any one of the above (1) to (8) with an active energy ray,
(10) An optical disk obtained by applying the ultraviolet-curable resin composition for an optical disk according to any one of the above (1) to (8) to an optical disk substrate having a reflective film comprising silver or a silver alloy and by irradiating an active energy ray,
(11) An optical disk having an ultraviolet-cured film of the ultraviolet-curable resin composition for an optical disk according to the above (1) on a reflective film comprising silver or a silver alloy,
(12) An ultraviolet-curable resin composition containing a sulfur-containing compound (A) represented by the formula (1), wherein R₁ and R₂ in the formula (1) of the above (1) are each independently a hydrogen atom, a hydroxy group, a C1-C4 alkyl group, a carboxy group or a halogen atom, and at least either thereof is a group other than a hydrogen atom, a photopolymerizable compound (B) and a photopolymerization initiator (C),

(13) The ultraviolet-curable resin composition according to the above (12), which contains the following components:
   Component (B-1): at least either epoxy (meth)acrylate or urethane (meth)acrylate;
   and
   Component (B-2): a (meth)acrylate monomer;
   as the photopolymerizable compound (B),
(14) The ultraviolet-curable resin composition according to (13), wherein the (meth)acrylate monomer as the component (B-2) is at least one kind selected from the group consisting of C5-C10 aliphatic glycol di(meth)acrylate; poly C2-C4 alkylene glycol di(meth)acrylate; C2-C3 alkylene oxide-modified bisphenol compound di(meth)acrylate; C5-C10 cyclo ring-(meth)acrylate which may contain oxy C1-C3 alkyl between the cyclo ring and the (meth)acrylate group, as a cross-linking group; and C2-C4 alkylene oxide-modified phenol (meth)acrylate,
(15) The ultraviolet-curable resin composition according to the above (13) or (14), wherein the epoxy (meth)acrylate of the component (B-1) is bisphenol compound-diglycidyl ether (meth)acrylate and the urethane (meth)acrylate is polyether urethane (meth)acrylate,
(16) The ultraviolet-curable resin composition according to the above (12), wherein the sulfur-containing compound (A) is at least one kind selected from the group consisting of 3-ethyl-4-hydroxythiophenol, 4-mercaptophenol and thiosalicylic acid, the component (B-1) is at least either bisphenol A diglycidyl ether diacrylate or urethane (meth)acrylate, the component (B-2) is at least one kind selected from the group consisting of ethylene oxide-modified bisphenol A type diacrylate, dipropylene glycol diacrylate, tripropylene glycol diacrylate, 1,6-hexanediol diacrylate, dicyclopentadiene oxyethyl acrylate and ethylene oxide-modified phenol acrylate (phenoxypolyethylene glycol acrylate).

### Effect of the Invention

When the ultraviolet-curable resin composition of the present invention is used for an optical disk using silver or a silver alloy for the reflective film, particularly for the adhesive layer of DVD and the like or the light transmitting layer of Blu-ray Disc and the like, an optical disk having a high durability can be obtained even though said resin does not have a high crosslink density, and an optical disk having a high reliability even in use for long hours under high temperature and high humidity can be provided.

### Best Mode for Carrying Out the Invention

The ultraviolet-curable resin composition of the present invention contains a particular sulfur-containing compound (A) represented by the above formula (1), a photopolymerizable compound (B) and a photopolymerization initiator (C).

The sulfur-containing compound (A) contained in the composition of the present invention is represented by the following formula (1):

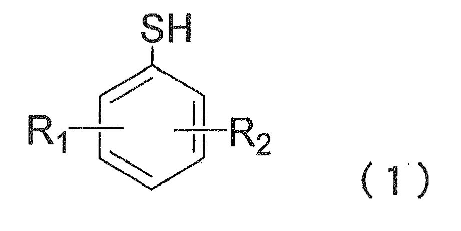

(wherein, R₁ and R₂ each independently represent a hydrogen atom, a hydroxy group, an alkyloxy group, an alkyl group, an aryl group, a carboxy group, an alkylthio ether group or a halogen atom).
The sulfur-containing compound represented by the formula (1) is preferably a compound where either R₁ or R₂ is a hydrogen atom or an alkyl group and the other is a hydrogen atom, a hydroxy group, an alkyloxy group, an alkyl group, an aryl group, a carboxy group, an alkylthio ether group or a halogen atom, more preferably the other is a hydroxy group, a carboxy group or an halogen atom, and further preferably the other is a hydroxy group or a carboxy group.
In addition, more preferably compounds can include a compound where R₁ and R₂ are each independently a hydrogen atom, a hydroxy group, a C1-C4 alkyl group, a carboxy group or a halogen atom and at least either is a group other than a hydrogen atom, and further preferably a compound where they are each independently a hydrogen atom, a C1-C4 alkyl group, a hydroxy group or a carboxy group and at least either is a group other than a hydrogen atom.
Furthermore, preferable specific examples thereof include thiophenol, 4-mercaptophenol, 3-mercaptophenol, 4-methoxythiophenol, 4-mercapto-2-methylphenol, 4-mercapto-2-ethylphonol, 3-ethyl-4-hydroxythiophenol, 4-mercapto-2-methylphenol, thiosalicylic acid, 4-tert-butylthiophenol and 4-chlorothiophenol.
Particularly preferable ones include 3-ethyl-4-hydroxythiophenol, 4-mercaptophenol and thiosalicylic acid.

The content of the component (A) in the ultraviolet-curable resin composition is usually 0.001 to 5% by weight, preferably 0.005 to 3% by weight, more preferably 0.1 to 1% by weight and further preferably 0.1 to 0.5% by weight, relative to the whole volume of said composition. Less than 0.001 % by weight thereof has no effects and the content of more than 5% by weight leads to no improvement of durability and light fastness, resulting in economic disadvantage.

As the photopolymerizable compound (B) contained in the composition of the present invention, a (meth)acrylate compound having one or more, preferably 1 to 6 and more preferably 1 to 3 (meth)acryloyl groups can be used. The (meth)acrylate compound is not particularly limited but preferably an epoxy (meth)acrylate and/or an urethane (meth)acrylate used as the component (B-1), a (meth)acrylate monomer used as the component (B-2), and the like.
In this regard, "(meth)acrylate" means "methacrylate or acrylate" in the present invention.

The epoxy (meth)acrylate used as the component (B-1) has a function of improving the curability and improving the hardness of the cured products and the curing speed.
Said epoxy (meth)acrylate is preferably a compound (glycidyl ether group-containing epoxy compound-(meth)acrylate) obtained by reaction of a glycidyl ether-type epoxy compound (glycidyl ether group-containing epoxy compound) with (meth)acrylic acid.
Said epoxy compound used for said reaction is preferably a bisphenol compound-diglycidyl ether such as diglycidyl ether of a bisphenol compound, diglycidyl ether of an alkylene oxide (preferably C2-C3 alkylene oxide)-added bisphenol compound, diglycidyl ether of a hydrogen-added bisphenol compound and diglycidyl ether of an alkylene oxide (preferably C2-C3 alkylene oxide)-added hydrogen-added bisphenol compound; diglycidyl ether of C1-C8 aliphatic glycol; diglycidyl ether of poly C2-C4 alkylene glycol; and the like.

Preferable bisphenol compounds in the above bisphenol compound-diglycidyl ether can include bisphenol A or F, hydrogen-added bisphenol A or F, alkylene oxide-added compounds thereof, and the like. The alkylene oxide can preferably include C2-C3 alkylene oxides, for example, ethylene oxide, propylene oxide and the like.
In addition, the C1-C8 aliphatic glycol in the above diglycidyl ether of C1-C8 aliphatic glycol can include ethylene glycol, propylene glycol, neopentyl glycol, butanediol, hexane diol, cyclohexane dimethanol or the like.
The poly C2-C4 alkylene glycol in the above diglycidyl ether of poly C2-C4 alkylene glycol can include diethylene glycol, trialkylene glycol, polyethylene glycol, polypropylene glycol or the like.

The epoxy (meth)acrylate used as the component (B-1) is preferably the above glycidyl ether group-containing epoxy compound-(meth)acrylates, and further, bisphenol compound-diglycidyl ether (meth)acrylate is preferable among them.
Said bisphenol compound-diglycidyl ether can include diglycidyl ether of bisphenol A or alkylene oxide-added bisphenol A, diglycidyl ether of bisphenol F or alkylene oxide-added bisphenol F, diglycidyl ether of hydrogen-added bisphenol A or alkylene oxide-added hydrogen-added bisphenol A, diglycidyl ether of hydrogen-added bisphenol F or alkylene oxide-added hydrogen-added bisphenol F, and the like.
In addition, the diglycidyl ether of the above C1-C8 aliphatic glycol can include ethylene glycol diglycidyl ether, propylene glycol diglycidyl ether, neopentyl glycol diglycidyl ether, butanediol diglycidyl ether, hexanediol diglycidyl ether, cyclohexanedimethanol diglycidyl ether and the like.
Further, the diglycidyl ether of the above poly C2-C4 alkylene glycol can include polypropylene glycol diglycidyl ether and the like.
Among the above, bisphenol A diglycidyl ether is most preferable.

The epoxy (meth)acrylate can be obtained by reacting the above glycidyl ether compound with (meth)acrylic acid in a conventional manner. For example, it can be obtained by reaction under the conditions as described below.

(Meth)acrylic acid is reacted in an ratio of 0.9 to 1.5 mol and more preferably 0.95 to 1.1 mol relative to 1 equivalent of epoxy group of the glycidyl ether type epoxy compound. The reaction temperature is preferably 80 to 120°C and the reaction time is approximately 10 to 35 hours. In order to accelerate the reaction, it is preferable to use a catalyst such as, for example, triphenylphosphine, TAP, triethanolamine or tetraethyl ammonium chloride. In addition, it is also possible to use an polymerization inhibitor (for example, paramethoxyphenol, methylhydroquinone and the like) in order to prevent polymerization during the reaction.

The epoxy (meth)acrylafie used as the component (B-1) is preferably (meth)acrylate (bisphenol compound-diglycidyl ether (meth)acrylate) obtained by reacting diglycidyl ether of a bisphenol compound with (meth)acrylic acid and more preferably bisphenol A epoxy (meth)acrylate (bisphenol A diglycidyl ether (meth)acrylate) obtained from a bisphenol A type epoxy compound.
The molecular weight of the epoxy (meth)acrylate used as the component (B-1) is preferably 500 to 10000.

The urethane (meth)acrylate used as the component (B-1) in the present invention has a function of improving the mechanical properties (for example, decrease warping, distortion and/or the like) of an optical disk laminated using the ultraviolet-curable resin composition of the present invention.
The urethane (meth)acrylate is obtained by reacting polyhydric alcohol, organic polyisocyanate and a hydroxy (meth)acrylate compound.

The above polyhydric alcohol include, for example, aliphatic polyhydric alcohol such as C2-C10 aliphatic alcohol having 2 to 5 hydroxy groups [specifically, neopentyl glycol, 3-methyl-1,5-pentanediol, ethylene glycol, propylene glycol, 1,4-butanediol, 1,6-hexanediol, trimethylolpropane, pentaerythritol, bis-(hydroxymethyl) -cyclohexane and the like] or tricyclodecanedimethylol, polyester polyol, caprolactone alcohol, polycarbonate polyol, polyether polyol or the like.
The above polyester polyol can include polyhydric alcohol and preferably polyester polyol which is obtained by reaction of the above aliphatic polyhydric alcohol with polybasic acid. The polybasic acid used here can include, for example, C2-C10 aliphatic dicarboxylic acid (succinic acid, adipic acid, azelaic acid or the like) or phthalic acids (phthalic acid, hexahydrophthalic anhydride, terephthalic acid, tetrahydrophthalic anhydride and the like).
The above caprolactone alcohol can include polyhydric alcohols and preferably caprolactone alcohol which is obtained by reaction of the above aliphatic polyhydric alcohol with epsilon -caprolactone.

The above polycarbonate polyol can include, for example, polycarbonate diol and the like which is obtained by reaction of a diol listed in the section of polyhydric alcohol, such as 1,6-hexanediol, with diphenyl carbonate, and the like.
The above polyether polyol (preferably polyether diol) can include, for example, polyalkylene glycol such as polyethylene glycol, polypropylene glycol and polytetramethylene glycol and preferably poly C2-C4 alkylene glycol, ethylene oxide-modified bisphenol A or the like. Among these, poly C2-C4 alkylene glycol is preferable. The poly C2-C4 alkylene glycol can include ones having a molecular weight of approximately 100 to 10000, preferably approximately 300 to 5000, more preferably approximately 300 to 2000 and most preferably approximately 300 to 1500.

The organic polyisocyanate for the above urethane (meth)acrylate synthesis is preferably a diisocyanate compound, including, for example, isophorone diisocyanate, hexamethylene diisocyanate, tolylene diisocyanate, xylene diisocyanate, diphenyl methane-4,4'-diisocyanate, dicyclopentanyl isocyanate or the like, and isophorone diisocyanate is more preferable.
In addition, the hydroxy (meth)acrylate compound for the above urethane (meth)acrylate synthesis includes, for example, hydroxy C2-C10 aliphatic hydrocarbon (meth)acrylate, for example, hydroxyethyl (meth)acrylate, hydroxy propyl (meth)acrylate, hydroxybutyl (meth)acrylate, dimethylol cyclohexyl mono(meth)acrylate or the like, hydroxy caprolactone (meth)acrylate and the like, and hydroxy C2-C10 aliphatic hydrocarbon (meth)acrylate is more preferable.

The above urethane (meth)acrylate synthesis reaction can be carried out in a conventional manner, for example, as follows.
That is, organic polyisocyanate is mixed with polyhydric alcohol so that the isocyanate group is preferably 1.1 to 2.0 equivalents relative to 1 equivalent of the hydroxy group, and they are reacted at a reaction temperature of preferably 70 to 90°C to synthesize urethane oligomer. Then a hydroxy (meth)acrylate compound is mixed therewith so that the hydroxy group is preferably 1 to 1.5 equivalents relative to 1 equivalent of the isocyanate group of the urethane oligomer, and the intended urethane (meth)acrylate can be obtained by reacting them at 70 to 90°C.
Said urethane (meth)acrylate is preferably polyether urethane acrylate using polyether polyol and preferably polyether diol as the polyhydric alcohol.
In addition, as said urethane (meth)acrylate, a commercial product can be used and it is available as, for example, UX-6101: polyether-based urethane acrylate (manufactured by Nippon Kayaku Co., Ltd.) and the like.
The molecular weight of the urethane (meth)acrylate used as the component (B-1) is preferably 400 to 10000.

The (meth)acrylate monomer as the component (B-2) of the photopolymerizable compound (B) is not particularly limited except for the epoxy (meth)acrylate and urethane (meth)acrylate used as the above component (B-1).
For example, the (meth)acrylate monomer having 1 (meth)acryloyl group can include phenoxy (C2-C4 alkyl) (meth)acrylate which may be substituted by a hydroxy group or the like, such as phenoxyethyl (meth)acrylate or 2-hydroxy-3-phenoxypropyl (meth)acrylate; C2-C4 alkylene oxide-modified phenol (meth)acrylate, for example, phenoxy (poly C2-C4 alkylene glycol)(meth)acrylate such as phenoxy (polyethylene or polypropylene) glycol (meth)acrylate such as ethylene oxide or propylene oxide 2 to 10 mol-modified phenol acrylate; benzyl (meth)acrylate; an oxygen or nitrogen atom-containing C5-C6 heterocyclic ring (meth)acrylate such as tetrahydrofurfuryl (meth)acrylate or morpholine (meth)acrylate; phenyl glycidyl (meth)acrylate; C1-C20 alkyl (meth)acrylate which may have a hydroxy substituent, such as 2-hydroxypropyl (meth)acrylate, lauryl (meth)acrylate, isodecyl (meth)acrylate, stearyl (meth)acrylate, isooctyl (meth)acrylate and tridecyl (meth)acrylate;

C1-C4 alkoxy poly C2-C4 alkylene glycol (meth)acrylate such as ethoxydiethylene glycol (meth)acrylate and methoxyditripropylene glycol (meth)acrylate; C5-C10 cyclo ring-(meth)acrylate (which may contain an oxy C1-C3 alkyl cross-linking group between the cyclo ring and the (meth)acrylate group) such as tricyclodecane (meth)acrylate, isobornyl (meth)acrylate, dicyclopentadiene oxyethyl (meth)acrylate {for example, dicyclopentenyloxyethyl acrylate (for example, FANCRYL FA-512A manufactured by Hitachi Chemical Co., Ltd.), dicyclopentenyloxyethyl methacrylate (for example, FANCRYL FA-512M manufactured by Hitachi Chemical Co., Ltd.)}, dicyclopentenyl acrylate (for example, FANCRYL FA-511A manufactured by Hitachi Chemical Co., Ltd.), dicyclopentanyl acrylate (for example, FANCRYL FA-513A manufactured by Hitachi Chemical Co., Ltd.), dicyclopentanyl methacrylate (for example, FANCRYL FA-513M manufactured by Hitachi Chemical Co., Ltd.) and 1-adamantyl acrylate (for example, Adamantate AA manufactured by Idemitsu Kosan Co., Ltd.), 2-methyl-2-adamantyl acrylate (for example, Adamantate MA manufactured by Idemitsu Kosan Co., Ltd.), 2-ethyl-2-adamantyl acrylate (for example, Adamantate EA manufactured by Idemitsu Kosan Co., Ltd.), 1-adamantyl methacrylate (for example, Adamantate AM manufactured by Idemitsu Kosan Co., Ltd.); phosphoric acid (meth)acrylate; and the like.
The (meth)acrylate monomer having 1 (meth)acryloyl group has a function of improving the mechanical properties (warping, distortion and the like) of an optical disk laminated using the resin composition of the present invention.

The (meth)acrylate monomer having 2 (meth)acryloyl groups which can be used as the photopolymerizable compound (B) can include C5-C10 cyclo ring di(meth)acrylate (which may contain a C1-C3 alkyl cross-linking group between the cyclo ring and the (meth)acrylate group) such as cyclohexane-1,4-dimethanol di(meth)acrylate, cyclohexane-1,3-dimethanol di(meth)acrylate, tricyclodecanedimethylol di(meth)acrylate (for example, KAYARAD R-684, tricyclodecanedimethylol diacrylate, and the like manufactured by Nippon Kayaku Co., Ltd.) and dicyclopentanyl di(meth)acrylate; dioxane glycol di(meth)acrylate (for example, KAYARAD R-604, dioxane glycol diacrylate manufactured by Nippon Kayaku Co., Ltd.); C5-C10 aliphatic glycol di(meth)acrylate (which may be one modified by alkylene oxide, for example, C2-C3 alkylene oxide and to which hydroxy pivalic acid is added) such as 1,6-hexanediol di(meth)acrylate, alkylene oxide-modified 1,6-hexanediol di(meth)acrylate, neopentyl glycol di(meth)diacrylate, alkylene oxide-modified neopentyl glycol di(meth)diacrylate, hydroxypivalic acid neopentyl glycol di(meth)acrylate and 1,9-nonanediol di(meth)acrylate; poly C2-C4 alkylene glycol di(meth)acrylate (preferably di- or tripropylene glycol di(meth)acrylate) such as polyethylene glycol di(meth)acrylate or polypropylene glycol di(meth)acrylate; C2-C3 alkylene oxide-modified bisphenol compound di(meth)acrylate (preferably ethylene oxide-modified bisphenol A type di(meth)acrylate) such as ethylene oxide-modified bisphenol A type di(meth)acrylate; and the like.

The (meth)acrylate monomer (B-2) having 3 (meth)acryloyl groups which can be used as the photopolymerizable compound (B) can include trimethylolpropane tri(meth)acrylate, trimethyloloctane tri(meth)acrylate, trimethylolpropane polyethoxy tri(meth)acrylate, trimethylolpropane polypropoxy tri(meth)acrylate, trimethylolpropane polyethoxy polypropoxy tri(meth)acrylate, tris[(meth)acroyloxyethyl]isocyanurate, caprolactone-modified tris[(meth)acryloyloxyethyl]isocyanurate, pentaerythritol tri(meth)acrylate, ethylene oxide-modified trimethylolpropane tri(meth)acrylate, propylene oxide-modified trimethylolpropane tri(meth)acrylate and the like.

The (meth)acrylate monomer (B-2) having 4 (meth)acryloyl groups which can be used as the photopolymerizable compound (B) can include pentaerythritol polyethoxy tetra(meth)acrylate, pentaerythritol polypropoxy tetra(meth)acrylate, pentaerythritol tetra(meth)acrylate, ditrimethylolpropane tetra(meth)acrylate, dipentaerythritol tetra(meth)acrylate and the like.

The (meth)acrylate monomer (B-2) having 5 (meth)acryloyl groups which can be used as the photopolymerizable compound (B) can include dipentaerythritol penta(meth)acrylate, caprolactone-modified dipentaerythritol penta(meth)acrylate and the like.

The (meth)acrylate monomer (B-2) having 6 (meth)acryloyl groups which can be used as the photopolymerizable compound (B) can include dipentaerythritol hexa(meth)acrylate, caprolactone-modified dipentaerythritol hexa(meth)acrylate and the like. In this regard, the (meth)acrylate monomer which can be used in the present invention may be also a polyfunctional one having 7 or more (meth)acryloyl groups.
Preferable ones as the (meth)acrylate monomer which can be used as the component (B-2) can include C5-C10 aliphatic glycol di(meth)acrylate and preferably 1,6-hexanediol di(meth)acrylate; poly C2-C4 alkylene glycol di(meth)acrylate; C2-C3 alkylene oxide-modified bisphenol compound di(meth)acrylate and preferably ethylene oxide-modified bisphenol A di(meth)acrylate; C5-C10 cyclo ring compound mono (meth)acrylate and preferably dicyclopentadiene oxyethyl (meth)acrylate; phosphoric acid (meth)acrylate; C2-C4 alkylene oxide-modified phenol (meth)acrylate and preferably ethylene oxide-modified phenol (meth)acrylate; and the like, and one kind or two or more kinds of these may be also used in combination.

In the resin composition of the present invention, one kind or two or more kinds of these can be used, as the component (B), in mixture at an optional ratio.
The content of the component (B) in said resin composition is the rest of the whole volume of the composition minus the content of the sulfur-containing compound (A), the photopolymerization initiator (C) and an optional additive, and it is usually 80 to 98% by weight and preferably 85 to 98% by weight.
As the component (B), at least either the component (B-1) or the component (B-2) may be contained, and it is preferable that the both the component (B-1) and the component (B-2) are contained.

When both the component (B-1) and the component (B-2) are contained as the component (B), the combination of the both may be any combination of the compounds.
As for their preferable combinations, when the component (B-1) is only epoxy (meth)acrylate in the above (1), poly(meth)acrylate monomers having 2-4 (meth)acrylate groups are preferable as the component (B-2) and di(meth)acrylate monomers are further preferable, and among di(meth)acrylate monomers, poly C2-C3 alkylene glycol di(meth)acrylate or C5-C6 alkylene glycol di(meth)acrylate is preferable. When the component (B-1) is only urethane (meth)acrylate in the above (2) or comprises both epoxy (meth)acrylate and urethane (meth)acrylate, the component (B-2) is C2-C3 alkylene oxide-modified bisphenol compound di(meth)acrylate, and preferably ethylene oxide-modified bisphenol A di(meth)methacrylate. In this case, further, as the component (B-2), C5-C10 cyclo ring compound mono or di(meth)acrylate, preferably dicyclopentadiene oxyethyl (meth)acrylate or C5-C6 alkylene glycol di(meth)acrylate, and preferably 1,6-hexanediol di(meth)acrylate is preferably contained.
In any of the above (1) and (2), it is more preferable in some cases to further contain phosphoric acid (meth)acrylate as the component (B-2).

When both the component (B-1) and the component (B-2) are contained as the component (B), the ratio of the both may be any, but usually the component (B-1) is approximately 20 to 65% by weight and the component (B-2) is approximately 35 to 80% by weight relative to the total amount of the component (B), and more preferably the component (B-1) is approximately 30 to 60% by weight and the component (B-2) is approximately 40 to 70% by weight.

In the resin composition of the present invention, phosphoric acid (meth)acrylate can be added as the component (B) according to necessity. The phosphoric acid (meth)acrylate improves adhesiveness between aluminum, silver or an silver alloy and an adhesive cured product but may corrode metal films, and therefore its use amount is limited.

The phosphoric acid (meth)acrylate which can be contained in the resin composition of the present invention is not limited to monoester, diester, triester or the like as long as it is (meth)acrylate having a phosphoric acid ester skeleton, and it includes, for example, ethylene oxide-modified phenoxylated phosphoric acid (meth)acrylate, ethylene oxide-modified butoxylated phosphoric acid (meth)acrylate, ethylene oxide-modified octyloxylated phosphoric acid (meth)acrylate, ethylene oxide-modified phosphoric acid di(meth)acrylate, ethylene oxide-modified phosphoric acid tri(meth)acrylate and the like and is available as PM-2 (ethylene oxide-modified phosphoric acid dimethacrylate) and the like manufactured by Nippon Kayaku Co., Ltd.. In the present invention, ethylene oxide-modified phosphoric acid dimethacrylate is preferably used. One kind or two or more kinds of phosphoric acid (meth)acrylate can be used in mixture at an optional ratio. When phosphoric acid (meth)acrylate is contained in the resin composition of the present invention, its content is usually 0.005 to 5% by weight, preferably 0.005 to 3% by weight and further preferably 0.005 to 1 % by weight. In addition, in some cases, it is preferably 0.05 to 3% by weight. It may be also 0.005 to 0.05% by weight particularly when the component (B-1) is only urethane (meth)acrylate in the above (2) or contains both epoxy (meth)acrylate and urethane (meth)acrylate.

The photopolymerization initiator (C) contained in the composition of the present invention is not particularly limited and includes, for example, 1-hydroxycyclohexylphenyl ketone (Irgacure 184; manufactured by Ciba Specialty Chemicals), 2-hydroxy-2-methyl-[4-(1-methylvinyl)phenyl]propanol oligomer (Esacure ONE-Refined; manufactured by Nihon Siber Hegner K.K.), 1-[4-(2-hydroxyothoxy)-phenyl]-2-hydroxy-2-methyl-1-propan-1-one (Irgacure 2959; manufactured by Ciba Specialty Chemicals), 2-hydroxy-1-{4-[4-(2-hydroxy-2-methyl-propionyl)-benzyl]-phenyl}-2-methyl-propan-1-one (Irgacure 127; manufactured by Ciba Specialty Chemicals), 2,2-dimethoxy-2-phenylacetophenone (Irgacure 651; manufactured by Ciba Specialty Chemicals), 2-hydroxy-2-methyl-1-phenyl-propan-1-one (Darocur 1173; manufactured by Ciba Specialty Chemicals), 2-methyl-1-[4-(methylthio)phenyl]-2-morpholinopropan-1-one (Irgacure 907; manufactured by Ciba Specialty Chemicals), 2-benzyl-2-dimethylamino-1-(4-morpholinophenyl)-butan-1-one, 2-chlorothioxanthone, 2,4-dimethylthioxanthone, 2,4-diisopropylthioxanthone, isopropylthioxanthone, 2,4,6-trimethylbenzoyldiphenylphosphineoxide, bis(2,4,6-trimethylbenzoyl)-phenylphosphineoxide, bis(2,6-dimethoxybenzoyl)-2,4,4-trimethylpentylphosphineoxide and the like.

Among them, 1-hydroxycyclohexylphenyl ketone, 2-benzyl-2-dimethylamino-1-(4-morpholinophenyl)-butan-1-one, 2,4,6-trimethylbenzoyldiphenylphosphine oxide, bis(2,4,6-trimethylbenzoyl)-phenylphosphine oxide, 2-hydroxy-2-methyl-[4-(1-methylvinyl)phenyl]propanol oligomer, 2-hydroxy-1-{4-[4-(2-hydroxy-2-methyl-propionyl)-benzyl]-phenyl}-2-methyl-propan-1-one, 1-[4-(2-hydroxyethoxy)-phenyl-]-2-hydroxy-2-methyl-1-propan-1-one and the like are preferable.

In the resin composition of the present invention, one kind or two or more kinds of these can be used, as the component (C), in mixture at an optional ratio. The content of the component (C) in the resin composition (content relative to the total amount) is usually 0.5 to 20% by weight and preferably 1 to 10% by weight. In addition, in some cases, the preferable content is 2 to 15% by weight, and particularly when the component (B-1) in the above (1) is only epoxy (meth)acrylate, the content of said resin composition relative to the total amount is 2 to 15% by weight and more preferably approximately 5 to 12% by weight.

From the above, the preferable ultraviolet-curable resin compositions in the present invention are summarized as follows:
(1) An ultraviolet-curable resin composition containing a sulfur-containing compound (A) represented by the above formula (1), a photopolymerizable compound (B) and a photopolymerization initiator (C);
(2) The ultraviolet-curable resin composition according to the above (1) wherein R₁ and R₂ are each independently a hydrogen atom, a hydroxy group, a C1-C4 alkyl group, a carboxy group or a halogen atom and at least either is a group other than a hydrogen atom;
(3) The ultraviolet-curable resin composition according to the above (1) or (2), which contains:
   Component (B-1); at least either epoxy (meth)acrylate or urethane (meth)acrylate,
   and
   Component (B-2); a (meth)acrylate monomer,
   as the photopolymerizable compound (B);
(4) The ultraviolet-curable resin composition according to any one of the above (1) to (3), wherein the epoxy (meth)acrylate as the component (B-1) is bisphenol diglycidyl ether di(meth)acrylate;

(5) The ultraviolet-curable resin composition according to any one of the above (1) to (4), wherein the (meth)acrylate monomer as the component (B-2) is at least one kind selected from the group consisting of C5-C10 aliphatic glycol di(meth)acrylate; poly C2-C4 alkylene glycol di(meth)acrylate; C2-C3 alkylene oxide-modified bisphenol compound di(meth)acrylate; C5-C10 cyclo ring-(meth)acrylate containing oxy C1-C3 alkyl as a cross-linking group between the cyclo ring and the (meth)acrylate group; or phenoxy (C2-C4 alkyl) (meth)acrylate which may be substituted by a hydroxy group or the like or its C2-C4 alkylene glycol-modified compound;
(6) The ultraviolet-curable resin composition according to the above (5), wherein the (meth)acrylate monomer as the component (B-2) is at least one kind selected from the group consisting of ethylene oxide-modified bisphenol A type di(meth)acrylate, dipropylene glycol di(meth)acrylate, tripropylene glycol di(meth)acrylate, 1,6-hexanediol di(meth)acrylate, dicyclopentadiene oxyethyl (meth)acrylate and ethylene oxide-modified phenoxyethyl (meth)acrylate;
(7) The ultraviolet-curable resin composition according to any one of the above (1) to (6), wherein the sulfur-containing compound (A) is at least one kind selected from the group consisting of 3-ethyl-4-hydroxythiophenol, 4-mercaptophenol and thiosalicylic acid;
(8) The ultraviolet-curable resin composition according to any one of the above (1) to (7), wherein the content of the sulfur-containing compound (A) represented by the above formula (1) is 0.001 to 5% by weight and the content of the photopolymerization initiator (C) is usually 0.5 to 20% by weight and preferably 2 to 15% by weight relative to the whole volume of the resin composition, and the rest is a photopolymerizable compound (B);
(9) The ultraviolet-curable resin composition according to any one of the above (3) to (8), wherein the component (B-1) is 20 to 65% by weight and the component (B-2) is 35 to 80% by weight, more preferably the component (B-1) is 30 to 60% by weight and the component (B-2) is 40 to 70% by weight, relative to the total amount of the component (B); and
(10) The compounds according to the above (3) to (9), wherein a phosphoric acid (meth)acrylate compound is further contained as the component (B); and the like are included.

In addition, it is possible to use an amine which can be a photopolymerization initiator auxiliary agent, in combination with the above photopolymerization initiator. Amines which can be used include benzoic acid 2-dimethylaminoethyl ester, dimethylaminoacetophenone, ethyl p-dimethylaminobenzoate, isoamyl p-dimethylaminobenzoate or the like. When a photopolymerization initiator auxiliary agent such as said amines is used, its content in the resin composition for adhesion of the present invention is usually 0.005 to 5% by weight and preferably 0.01 to 3% by weight.

In the resin composition of the present invention, an additive such as an antioxidant, an organic solvent, a silane coupling agent, a polymerization inhibitor, a leveling agent, an antistatic agent, a surface lubricant, a fluorescent brightening agent, a light stabilizer (for example, a hindered amine compound and the like) and a filler may be added according to necessity.
Specific examples of the hindered amine compound include, for example, 1,2,2,6,6-pentamethyl-4-piperidyl alcohol, 2,2,6,6-tetramethyl-4-piperidyl alcohol, 1,2,2,6,6-pentamethyl-4-piperidyl (meth)acrylate (LA-82), 2,2,6,6-tetramethyl-4-piperidyl (meth)acrylate, and in addition, CHIMASSORB 119FL, CHIMASSORB 2020FDL, CHIMASSORB 944FDL, TINUVIN 622LD, TINUVIN 123S, TINUVIN 144, TINUVIN 765, TINUVIN 770DF, TINUVIN 111FDL, TINUVIN 783FDL, TINUVIN 791 FB, TINUVIN XT850FF and TINUVIN XT855FF manufactured by Ciba Specialty Chemicals, and the like.

The resin composition of the present invention can be obtained by mixing and dissolving the above described components at an ordinary temperature to 80°C. In addition, according to necessity, foreign substances may be removed by an operation such as filtration. As for the resin composition of the present invention, it is preferable to appropriately control the mixing ratio of the components so that the viscosity at 25°C is in the range of 100 to 5000 mPa·s, in view of coating properties.

The resin composition of the present invention can be also used as a protective coating agent for optical disks, and suitable as an adhesive particularly for laminated type optical disks such as DVD or as a coating agent for light transmitting layers on the laser incident side of Blu-ray Disc and the like.
Hereinafter, the method for producing the optical disk using said resin composition will be specifically explained. The resin composition of the present invention is coated on an optical disk substrate by an optional method, for example, spin coating method, photo polymerization method, roll coating method, screen printing method and the like, so that the film thickness after coating is 1 to 150 µm. In the case where the intended optical disk is a laminated type, it can be obtained by further bonding one more optical disk substrate on the coated side and then by irradiating ultraviolet to near ultraviolet ray (wavelength: around 200 to 400 nm) (hereinafter, also referred to as ultraviolet ray for simplicity) from one side or the both sides to cure the coating layer (adhesive layer) and thereby the two optical disk substrates are bonded. In addition, in the case where the intended optical disk is a Blu-ray Disc or the like and said coating film is a light transmitting layer, it is obtained by directly irradiating said coating film with ultraviolet to near ultraviolet ray (wavelength: around 200 to 400 nm) from one side or the both sides to cure said coating film.
The irradiation amount of said ultraviolet rays is preferably about 50 to 1500 mJ/cm² and particularly preferably, approximately 100 to 1000 mJ/cm². As the light source for irradiation of said ultraviolet ray, any lamp can be used as long as it allows irradiation of said ultraviolet ray. For example, it includes a low, high or ultrahigh pressure mercury lamp, a metal halide lamp, a (pulse) xenon lamp, an electrodeless lamp or the like.

The resin composition of the present invention is suitable for optical disks using silver or a silver alloy as a total reflective film or a semitransparent reflective film. However, it can be also used as a protective film or an adhesive for optical disk substrates using a material other than silver and a silver alloy, such as silicon or a silicon compound as a known semitransparent reflective film.

The present invention includes any optical disks having a cured product of the resin composition of the present invention. For example, it includes an optical disk obtained by using the resin composition of the present invention and irradiating ultraviolet rays to adhere two optical disk substrates, particularly a laminated optical disk where at least either of its optical disk substrates has a total reflective film or a semitransparent reflective film of silver or a silver alloy or an optical disk having a total reflective film or a semitransparent reflective film of silver or a silver alloy, for example, having a coated and cured film of said resin composition as a light transmitting layer on a 1.1 mm optical disk substrate, or also an optical disk having a light transmitting layer formed by laminating a transparent film comprising the resin composition on said optical substrate and by curing. Said optical disk can include DVD-ROM (DVD-5, DVD-10, DVD-9, DVD-14 and DVD-18), DVD-R, DVD+R, DVD-RW, DVD+RW, DVD-RAM, single-sided double-layer DVD-R, single-sided double-layer DVD+R, single-sided double-layer DVD-RW, single-sided double-layer DVD+RW, HD DVD-ROM, HD DVD-R, BD-ROM, BD-R, BD-RE and the like.

### Examples

Hereinafter, the present invention will be explained more specifically with reference to the Examples, but the present invention is not limited to these Examples.
Ultraviolet-curable resin compositions for Examples D1 to D5 and Comparative Examples D1 to D3 were prepared according to the composition shown in Table 1, and ultraviolet-curable resin compositions for Examples B1 to B7 and Comparative Examples B1 to B2 were prepared according to Table 2.

[Table 1]

**Table 1**

| | | Example D1 | Example D2 | Example D3 | Example D4 | Example D5 | Comparative Exam. D1 | comparative Exam. D2 | Comparative Exam. D3 |
|---|---|---|---|---|---|---|---|---|---|
| (Component A) | EHTP | | | | 0.25 | | | | |
| | PMP | 0.25 | 0.05 | 0.25 | | 0.25 | | | |
| | Thiosalicylic acid | | | | | 0.25 | | | |
| (Component B-1) | EPA | 52 | 52 | 55 | 55 | 55 | 55 | 55 | 52 |
| (Component B-2) | DPGDA | 53 | 53 | | | | | | 53 |
| | TPGDA | | | | 15 | | | | |
| | HDDA | | | 45 | 35 | 45 | 45 | 45 | |
| | PM-2 | | | 0.1 | 0.1 | 0.1 | 0.1 | | |
| (Component C) | Irgacure 184D | 7 | 10 | 10 | 10 | 10 | 10 | 10 | 7 |
| (Additive) | LA-82 | 0.50 | | 0.50 | | 0.50 | | | |
| | 2,2'-dithiodi(benzoic acid) | | | | | | | | 0.50 |
| | KBM-803 | | | | | | | 0.25 | |
| | Total | 112.75 | 115.05 | 110.85 | 115.35 | 110.85 | 110.10 | 110.25 | 112.50 |
| | | | | | | | | | |
| Viscosity | (mPa·s/25°C) | 440 | 435 | 395 | 400 | 390 | 390 | 395 | 440 |
| 80°C, 85% RH, 500 hours | | | | | | | | | |
| Plsum8 | Initial value | 4 | 6 | 6 | 5 | 5 | 6 | 4 | 6 |
| | 500 hours later | 10 | 17 | 15 | 12 | 15 | 620 | 315 | 520 |
| | Judgment | ○ | ○ | ○ | ○ | ○ | × | × | × |
| | | | | | | | | | |
| Appearance evaluation | Judgment | ○ | ○ | ○ | ○ | ○ | × | × | × |

[Table 2]

**Table 2**

| | | Example B1 | Example B2 | Example B3 | Example B4 | Example B5 | Example B6 | Example B7 | Comparative Exam. B1 | Comparative Exam. B2 |
|---|---|---|---|---|---|---|---|---|---|---|
| (Component A) | EHTP | | 0.15 | | | | | | | |
| | PMP | 0.75 | | | 0.15 | 0.15 | 0.15 | 0.15 | | |
| | Thiosalicylic acid | | | 0.15 | | | | | | |
| (Component B-1) | EPA | 10 | 10 | 10 | 10 | 10 | | | 10 | 10 |
| | UA-1 | 25 | 25 | 25 | 25 | 30 | 35 | 40 | 25 | 25 |
| (Component B-2) | BPE4A | | | | | 35 | | | | |
| | BPE-10 | 35 | 35 | 35 | 35 | | 35 | 30 | 35 | 35 |
| | TPGDA | | | | | | 31 | | | |
| | HDDA | | | | | | | 11 | | |
| | FA-512A | 31 | 31 | 31 | 31 | | | 20 | 31 | 31 |
| | PHE-2 | | | | | 25 | | | | |
| | PM-2 | 0.01 | 0.01 | 0.01 | 0.01 | | 0.01 | 0.01 | 0.01 | 0.01 |
| (Component C) | ONE-Refind | 4 | 4 | 4 | | 4 | 4 | 4 | 4 | 4 |
| | Irgacure 184D | | | | 4 | | | | | |
| (Additive) | LA-82 | 0.50 | 0.50 | 0.50 | | 0.50 | | 0.50 | 0.50 | |
| | L-7002 | 0.10 | 0.10 | | | 0.10 | | 0.10 | | 0.10 |
| | KBM-803 | | | | | | | | | 0.15 |
| | Total | 105.76 | 105.76 | 105.66 | 105.7 | 104.75 | 105.16 | 105.76 | 105.51 | 105.26 |
| | | | | | | | | | | |
| Viscosity (mPa·s/25°C) | | 1510 | 1630 | 1540 | 1950 | 2580 | 1800 | 1670 | 1480 | 1580 |
| 80°C, 85% RH, 250 hours | | | | | | | | | | |
| RSER | Initial value | 5.1E-05 | 3.3E-05 | 2.3E-05 | 2.2E-05 | 3.2E-05 | 1.8E-05 | 2.7E-05 | 2.1E-05 | 2-7E-05 |
| | 250 hours later | 8.5E-05 | 8.2E-05 | 1.3E-04 | 9.5E-05 | 7.5E-05 | 1.1E-04 | 8.8E-05 | 1.4E-02 | 1.4E-02 |
| | Judgment | ○ | ○ | ○ | ○ | ○ | ○ | ○ | × | × |
| | | | | | | | | | | |
| Appearance evaluation Judgment | | ○ | ○ | ○ | ○ | ○ | ○ | ○ | × | × |

In this regard, the components abbreviated in Table 1 and Table 2 are as follows:
EHTP: 3-ethyl-4-hydroxythiophenol;
PMP: 4-mercaptophenol;
EPA: bisphenol A diglycidyl ether diacrylate;
UA-1: reaction products of three components, polytetramethylene glycol (molecular weight: 850), isophorone diisocyanate and 2-hydroxyethyl acrylate, having a molar ratio of 1:2:2;
BPE4A: ethylene oxide 4 mol-modified bisphenol A type diacrylate, manufactured by Dai-ichi Kogyo Seiyaku Co., Ltd.;
BPE-10: ethylene oxide 10 mol-modified bisphenol A type diacrylate, manufactured by Dai-ichi Kogyo Seiyaku Co., Ltd.;
DPGDA: dipropylene glycol diacrylate;
TPGDA: tripropylene glycol diacrylate;
HDDA: 1,6-hexanediol diacrylate, manufactured by Nippon Kayaku Co., Ltd. ;
FA-512A: dicyclopentadiene oxyethyl acrylate, manufactured by Hitachi Chemical Co., Ltd.;
PHE-2: ethylene oxide 2 mol-modified phenol acrylate;
PM-2: ethylene oxide-modified phosphoric acid dimethacrylate, manufactured by Nippon Kayaku Co., Ltd.;
IRGACURE-184D: 1-hydroxycyclohexylphenyl ketone, manufactured by Ciba Specialty Chemicals;
Esacure ONE-Refined: 2-hydroxy-2-methyl-[4-(1-methylvinyl)phenyl]propanol oligomer, manufactured by Nihon Siber Hegner K.K.;
LA-82: 1,2,2,6,6-pentamethyl-4-piperidyl methacrylate, manufactured by ADEKA Corporation;
L-7002: silicone, manufactured by Dow Corning Toray Co., Ltd.;
KBM-803: 3-mercaptopropyltrimethoxysilane, manufactured by Shin-Etsu Chemical Co., Ltd.

Using the obtained ultraviolet-curable resin compositions of the present invention, DVD+Rs of lamination type and BD-ROMs of light transmitting layer type were produced and evaluated for their properties.

### Test example 1

Using ultraviolet-curable resin compositions obtained in Examples D1 to D5 or Comparative Examples D1 to D3 shown in Table 1, DVD+Rs of lamination type were produced according to the following process and evaluated.

### (I) Production of DVD+R of lamination type

1. A silver reflective film substrate was produced by making an azo dye recording layer, by spin coating method, on a PC substrate having a thickness of 0.6 mm where a pit for DVD+R had been formed, followed by drying at 80°C for 15 minutes, and then by sputtering using silver manufactured by Unaxis Japan Co., Ltd. so that the film thickness was 100 nm on average.
2. On the inner periphery of the silver reflective film substrate, 2.5 g of the ultraviolet-curable resin composition of the present invention were provided in a circle.
3. The 0.6 mm PC substrate was put on the silver reflective film substrate (with the sputtered surface upward) and spin-coated at a speed of 3000 rpm for 4 seconds to bond them so that the film thickness of the ultraviolet-curable resin composition of the present invention between the PC substrate and the silver reflective film was 35 to 55 µm. An apparatus manufactured by Global Machinery Co., Ltd. was used.
4. Using a xenon flash lamp, irradiation of 8 shots at 80 J was carried out from the upper side to cure the ultraviolet-curable resin composition of the present invention and thus to adhere the disk substrate. In this regard, the DVD disc was positioned with the PC substrate on the upper side and with the silver reflective film substrate on the lower side.
5. On the DVD+R substrate produced in the above 1 to 4, a signal of about 4.7 gigabyte was recorded at a writing rate of 8 times by a drive (model: DVR-110) manufactured by Pioneer Corporation.

### (II) Evaluation of change in the electric signals and appearance change of the reflective film before and after the durability test of DVD+R

The laminated optical disks of the present invention and the laminated optical disks of Comparative Examples were left for 500 hours under the circumstances of 80°C and 85% RH. Using a DVD data signal measuring device, DVD-CATS SA-300 manufactured by AUDIO DEV. Co., Ltd, the electric signals (PISum8) of the laminated optical disks were measured after the durability test and evaluated. PISum8 is one of the electric signals from an optical disk, and a higher numerical value means a more deteriorated data of laminated optical disk. In addition, the state of the reflective films was visually observed. The results of the evaluation are shown in Table 1 with the following notations.

Evaluation of PISum8:
○ ···PISum8 value of less than 280;
X ··· PISum8 value of 280 and more.
Reflective film appearance:
○ ··· No change is observed in the state of reflective film in the evaluation 500 hours later, compared with that immediately after adhesion;
X ··· Discoloration is observed in reflective film in the evaluation 500 hours later, compared with that immediately after adhesion.

### Test example 2

Using the ultraviolet-curable resin compositions obtained in Examples B1 to B7 or Comparative Examples B1 and B2 shown in Table 2, BD-ROMs of light transmitting layer type were produced by the method described below and evaluated according to the following method.

### (I) Production of BD-ROM of light transmitting layer type

1. A silver reflective film substrate was sputtered on a PC substrate having a thickness of 1.1 mm where a pit for BD-ROM had been formed using a silver alloy GB-100 manufactured by Kobe Steel, Ltd. so that the film thickness was 30 nm on average, and thus a disk substrate with a silver reflective film was produced.
2. The substrate was put on the spin table so that the silver reflective film is on the upward and cap treatment was carried in a circle pattern for covering until an internal diameter of 11.5 mm, and then 2.5g of an ultraviolet-curable resin composition of the present invention were provided on the cap of the center.
3. In accordance with the viscosity of the ultraviolet-curable resin composition of the present invention, spin coating was carried out at a rate ranging from 1000 rpm to 1500 rpm for 4 seconds to 7 seconds, and it was coated so that each coated film thickness was 95 µm to 105 µm. Shortly before completion of the spin coating, irradiation of 2 shots was carried out with a xenon flash lamp to cure it to the degree that the surface flowability disappeared.
4. Using a xenon flash lamp, irradiation of 8 shots at 80 J was carried out from the upper side to completely cure the ultraviolet-curable resin composition of the present invention and thus a BD-ROM having a light transmitting layer was obtained.
In this regard, it is possible to carry out hard coat treatment on the resin surface of the disk of the present invention, but the present evaluation was carried out without hard coat treatment because the durability of the light transmitting layer itself was evaluated.

### (II) Evaluation of change in the electric signals and appearance change of the reflective film before and after the durability test of BD-ROM

The optical disks of the present invention and the optical disks of Comparative Examples were left for 250 hours under the circumstances of 80°C and 85% RH. Using a Blu-ray Disc data signal measuring device, ODU-1000 manufactured by Pulstec Industrial Co., Ltd., the electric signal (RSER) of each laminated optical disk after the durability test was measured and evaluated. RSER is one of the electric signals from an optical disk, and a higher numerical value means a more deteriorated data of a laminated optical disk. In this regard, the state of reflective film was visually observed. The results of the evaluation are shown in Table 2 with the following notations.

Evaluation of RSER:
○ ··· RSER value of less than 2.0E-04 (representing 2.0×10⁻⁴);
× ··· RSER value of 2.0E-04 (representing 2.0 × 10⁻⁴) or more.
In this regard, "2.0E-04" as RSER represents for "2.0×10⁻⁴", and the same description in Table 2 has the same meaning. For example, 5.1 E-05 as the initial value in Example D1 represents "5.1×10⁻⁵" and the same holds for the other value descriptions.
Reflective film appearance:
○ ··· No change is observed in the state of reflective film in the evaluation 250 hours later, compared with that immediately after adhesion;
× ··· Discoloration is observed in reflective film in the evaluation 250 hours later, compared with that immediately after adhesion.

From the results of Table 1 and Table 2, it is found in the durability tests on DVD and Blu-ray Disc that the resin compositions of the present invention in Examples D1 to D5 and B1 to B7 containing the sulfur-containing compound represented by the formula (1) could provide good electrical properties. The electrical properties of Comparative Examples D1 to D3, B1 and B2 containing no sulfur compound represented by the formula (1) had poor results in the durability test.

### Industrial Applicability

The optical disks using the resin composition of the present invention are excellent in durability even if having a reflective film comprising silver or a silver alloy.

## Claims

1. An ultraviolet-curable resin composition for an optical disk having a reflective film comprising silver or a silver alloy which contains a sulfur-containing compound (A) represented by the following formula (1): 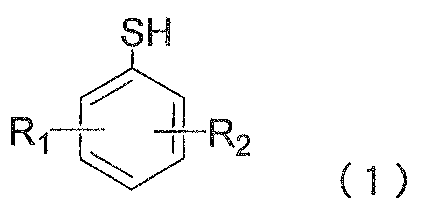 (wherein, R₁ and R₂ each independently represent a hydrogen atom, a hydroxy group, an alkyloxy group, an alkyl group, an aryl group, a carboxy group, an alkylthio ether group or a halogen atom)
a photopolymerizable compound (B) and a photopolymerization initiator (C).

2. The ultraviolet-curable resin composition for an optical disk according to Claim 1, which contains 0.001 to 5% by weight of the sulfur-containing compound (A) represented by the above formula (1) relative to the composition.

3. The ultraviolet-curable resin composition for an optical disk according to Claim 1, wherein the sulfur-containing compound (A) represented by the above formula (1) is thiophenol, 4-mercaptophenol, 3-mercaptophenol, 4-methoxythiophenol, 4-mercapto-2-methylphenol, 4-mercapto-2-ethylphenol, 3-ethyl-4-hydroxythiophenol, thiosalicylic acid, 4-tert-butylthiophenol or 4-chlorothiophenol.

4. The ultraviolet-curable resin composition for an optical disk according to Claim 1, which contains at least either epoxy (meth)acrylate or urethane (meth)acrylate (B-1) as the photopolymerizable compound (B).

5. The ultraviolet-curable resin composition for an optical disk according to Claim 4, which further contains a (meth)acrylate monomer (B-2) as the photopolymerizable compound (B).

6. The ultraviolet-curable resin composition for an optical disk according to Claim 5, wherein the (meth)acrylate monomer (B-2) is one or more kinds selected from the group consisting of dicyclopentenyloxyethyl (meth)acrylate, dipropylene glycol di(meth)acrylate, tripropylene glycol di(meth)acrylate, 1,6-hexanediol di(meth)acrylate, phenoxyethyl (meth)acrylate, phenoxypolyethylene glycol (meth)acrylate, 2-hydroxy-3-phenoxypropyl(meth)acrylate and ethylene oxide-modified bisphenol A type di(meth)acrylate.

7. The ultraviolet-curable resin composition for an optical disk according to any one of Claims 4 to 6, wherein the photopolymerizable compound (B) further contains phosphoric acid (meth)acrylate.

8. The ultraviolet-curable resin composition for an optical disk according to Claim 1, wherein the photopolymerization initiator (C) is one or more kinds selected from the group consisting of 1-hydroxycyclohexylphenyl ketone 2-benzyl-2-dimethylamino-1-(4-morpholinophenyl)-butan-1-one, 2,4,6-trimethylbenzoyldiphenylphosphine oxide, bis(2,4,6-trimethylbenzoyl)-phenylphosphine oxide, 2-hydroxy-2-methyl-[4-(1-methylvinyl)phenyl]propanol oligomer, 2-hydroxy-1-{4-[4-(2-hydroxy-2-methyl-propionyl)-benzyl]-phenyl}-2-methyl-propan-1-one and 1-[4-(2-hydroxyethoxy)-phenyl-]-2-hydroxy-2-methyl-1-propan-1-one.

9. A cured product obtained by irradiating the ultraviolet-curable resin composition for an optical disk according to any one of Claims 1 to 8 with an active energy ray.

10. An optical disk obtained by applying the ultraviolet-curable resin composition for an optical disk according to any one of Claims 1 to 8 to an optical disk substrate having a reflective film comprising silver or a silver alloy and by irradiating an active energy ray.

11. An optical disk having an ultraviolet-cured film of the ultraviolet-curable resin composition for an optical disk according to Claim 1 on a reflective film comprising silver or a silver alloy.

12. An ultraviolet-curable resin composition containing a sulfur-containing compound (A) represented by the formula (1), wherein R₁ and R₂ in the formula (1) of Claim 1 are each independently a hydrogen atom, a hydroxy group, a C1-C4 alkyl group, a carboxy group or a halogen atom, and at least either thereof is a group other than a hydrogen atom, a photopolymerizable compound (B) and a photopolymerization initiator (C).

13. The ultraviolet-curable resin composition according to Claim 12 , which contains the following components:
Component (B-1): at least either epoxy (meth)acrylate or urethane (meth)acrylate;
and
Component (B-2): a (meth)acrylate monomer;
as the photopolymerizable compound (B).

14. The ultraviolet-curable resin composition according to Claim 13, wherein the (meth)acrylate monomer as the component (B-2) is at least one kind selected from the group consisting of C5-C10 aliphatic glycol di(meth)acrylate; poly C2-C4 alkylene glycol di(meth)acrylate; C2-C3 alkylene oxide-modified bisphenol compound di(meth)acrylate; C5-C10 cyclo ring-(meth)acrylate which may contain oxy C1-C3 alkyl between the cyclo ring and the (meth)acrylate group, as a cross-linking group; phenoxy (C2-C4 alkyl) (meth)acrylate which may be substituted by a hydroxy group or the like; and C2-C4 alkylene oxide-modified phenol (meth)acrylate.

15. The ultraviolet-curable resin composition according to Claim 13 or 14, wherein the epoxy (meth)acrylate of the component (B-1) is bisphenol compound-diglycidyl ether (meth)acrylate and the urethane (meth)acrylate of the component (B-1) is polyether urethane (meth)acrylate.

16. The ultraviolet-curable resin composition according to Claim 12, wherein the sulfur-containing compound (A) is at least one kind selected from the group consisting of 3-ethyl-4-hydroxythiophenol, 4-mercaptophenol and thiosalicylic acid, the component (B-1) is at least either bisphenol A diglycidyl ether diacrylate or urethane (meth)acrylate, the component (B-2) is at least one kind selected from the group consisting of ethylene oxide-modified bisphenol A type diacrylate, dipropylene glycol diacrylate, tripropylene glycol diacrylate, 1,6-hexanediol diacrylate, dicyclopentadiene oxyethyl acrylate and ethylene oxide-modified phenol acrylate.
